# EUROPEAN PATENT APPLICATION

(11) **EP 4 231 340 A1**
(43) Date of publication of application: **23.08.2023**
(21) Application number: 21946244.7
(22) Date of filing: 28.12.2021
(51) Int. Cl.: H01L 21/68, H01L 21/60

(54) **BONDING SYSTEM AND BONDING COMPENSATION METHOD**

(30) Priority: 24.12.2021 CN 202111595542
(71) Applicant: HUBEI 3D SEMICONDUCTOR INTEGRATED INNOVATION CENTER CO., LTD., Wuhan, Hubei 430000 (CN); Hubei Yangtze Memory Laboratories, Wuhan, Hubei 430000 (CN)
(72) Inventor: TIAN, Yingchao, Wuhan, Hubei 430000 (CN); LIU, Tianjian, Wuhan, Hubei 430000 (CN); CAO, Ruixia, Wuhan, Hubei 430000 (CN); YU, Wenjing, Wuhan, Hubei 430000 (CN)
(74) Representative: Gevers Patents
(86) International application number: PCT/CN2021/142000
(87) International publication number: WO 2023/115610

(57) **Abstract**

Embodiments of the present disclosure provide a bonding system and a bonding compensation method. The bonding compensation method includes the following operations. A first deviation value between a current position of a picked first die and a first target position is determined. A second deviation value between a current position of a second die on a wafer and a second target position is determined. The wafer is moved according to the first deviation value and the second deviation value, to align the first die with the second die. The first die is bonded to the second die, after aligning the first die with the second die. A third deviation value between positions of the first die and the second die which have been bonded is determined. Calibration parameters for a to-be-bonded third die and a fourth die on the wafer are determined according to the third deviation value. The third die is bonded to the fourth die, according to the calibration parameters.

## Description

### CROSS-REFERENCE TO RELATED APPLICATIONS

This application is based on and claims priority to Chinese Patent Application No. 202111595542.4 filed on December 24, 2021 and entitled "BONDING SYSTEM AND BONDING COMPENSATION METHOD", the disclosure of which is hereby incorporated by reference in its entirety.

### TECHNICAL FIELD

Embodiments of the present disclosure relate to a bonding system and a bonding compensation method.

### BACKGROUND

In the field of semiconductor manufacturing, three-dimensional (3D) integration of semiconductor devices may be implemented by using bonding technologies. Performance of chips may be improved by bonding two or more semiconductor structures with the same or different functions. Furthermore, metal interconnection between to-be-bonded objects may also be greatly shortened, reducing heating, power consumption and delay.

Bonding processes may be distinguished by bonding objects, and include wafer to wafer bonding, die to wafer bonding and die to die bonding.

### SUMMARY

An embodiment of the present disclosure provides a bonding compensation method, including the following operations.

A first deviation value between a current position of a picked first die and a first target position is determined.

A second deviation value between a current position of a second die on a wafer and a second target position is determined.

The wafer is moved according to the first deviation value and the second deviation value, to align the first die with the second die.

The first die is bonded to the second die, after aligning the first die with the second die.

A third deviation value between positions of the first die and the second die which have been bonded is determined.

Calibration parameters for a to-be-bonded third die and a fourth die on the wafer are determined according to the third deviation value.

The third die is bonded to the fourth die, according to the calibration parameters.

In some embodiments, the operation of bonding the third die to the fourth die, according to the calibration parameters may include the following operations.

The wafer is moved based on the calibration parameters, so that the third die and the fourth die are located at to-be-bonded positions.

The third die is bonded to the fourth die.

In some embodiments, the operation of moving the wafer based on the calibration parameters may include the following operations.

A fourth deviation value between a current position of the third die which has been picked and a third target position is determined.

A fifth deviation value between a current position of the fourth die on the wafer and a fourth target position is determined.

The wafer is moved according to the fourth deviation value, the fifth deviation value and the calibration parameters, so that the third die and the fourth die are located at the to-be-bonded positions.

In some embodiments, the operation of moving the wafer according to the fourth deviation value, the fifth deviation value and the calibration parameters, so that the third die and the fourth die are located at the to-be-bonded positions may include the following operations.

At least the fourth deviation value or the fifth deviation value is calibrated based on the calibration parameters.

The wafer is moved according to the fourth deviation value and the fifth deviation value which have been calibrated, so that the third die and the fourth die are located at the to-be-bonded positions.

In some embodiments, the operation of moving the wafer based on the calibration parameters, so that the third die and the fourth die are located at to-be-bonded positions may include the following operations.

The wafer is moved to align the third die with the fourth die.

A compensation offset is determined based on the calibration parameters.

The wafer is moved according to the compensation offset, so that the third die and the fourth die are located at the to-be-bonded positions.

In some embodiments, the operation of moving the wafer to align the third die with the fourth die may include the following operations.

A fourth deviation value between a current position of the third die which has been picked and a third target position is determined.

A fifth deviation value between a current position of the fourth die on the wafer and a fourth target position is determined.

The wafer is moved according to the fourth deviation value and the fifth deviation value, to align the third die with the fourth die.

In some embodiments, the operation of determining the third deviation value between positions of the first die and the second die which have been bonded may include the following operations.

At least two third deviation values corresponding to at least two first dies and at least two second dies which have been bonded are determined.

The operation of determining calibration parameters for the to-be-bonded third die and the fourth die on the wafer, according to the third deviation value may include the following operations.

The at least two third deviation values are fitted to obtain a fitting function.

The calibration parameters are determined according to the fitting function.

In some embodiments, the operation of determining at least two third deviation values corresponding to at least two first dies and at least two second dies which have been bonded may include the following operations.

At least two adjacent dies on the wafer are determined as second dies, here dies to be bonded after the at least two second dies on the wafer are fourth dies.

The at least two third deviation values are determined, after bonding the at least two second dies to first dies corresponding to the second dies.

In some embodiments, the operation of determining calibration parameters for the to-be-bonded third die and the fourth die on the wafer, according to the third deviation value may include the following operations.

The calibration parameters are determined according to the at least two third deviation values, before bonding the fourth dies to be bonded after the second dies to respective third dies.

In some embodiments, the operation of determining at least two third deviation values corresponding to at least two first dies and at least two second dies which have been bonded may include the following operations.

In a process of bonding dies on the wafer in a predetermined order, at least two spaced dies on the wafer are sequentially determined as second dies at a predetermined frequency, here dies other than the second dies on the wafer are fourth dies.

Multiple third deviation values are determined at the predetermined frequency, after bonding the second dies to first dies corresponding to the second dies.

In some embodiments, the operation of determining calibration parameters for the to-be-bonded third die and the fourth die on the wafer, according to the third deviation value may include the following operations.

The calibration parameters are updated according to multiple third deviation values which are available currently, before bonding the to-be-bonded third die to the fourth die on the wafer.

In some embodiments, the method may further include the following operations.

The first die is debonded from the second die, in response to that the third deviation value is greater than a preset deviation threshold.

An embodiment of the present disclosure further provides a bonding system, including a bonding assembly, a wafer stage, a first alignment assembly, a second alignment assembly, a third alignment assembly, and a calibration assembly.

The bonding assembly includes a bonding head configured to pick a first die and a first optical path passing through the bonding head, here a first end of the first optical path is located at a picking surface where the bonding head picks the die.

The wafer stage is configured to carry a wafer.

The first alignment assembly is located at a second end of the first optical path, and is configured to determine a first deviation value between a current position of the first die and a first target position according to a detection optical signal transmitted in the first optical path.

The second alignment assembly is located at a side of the wafer stage away from the bonding assembly, and is configured to determine a second deviation value between a current position of a second die on the wafer and a second target position.

The wafer stage is further configured to drive, according to the first deviation value and the second deviation value, the carried wafer to move relative to the picking surface, to align the second die with the first die.

The bonding assembly is further configured to bond the first die to the second die.

The third alignment assembly is located at the side of the wafer stage away from the bonding assembly, and is configured to determine a third deviation value between positions of the first die and the second die which have been bonded.

The calibration assembly is configured to determine calibration parameters for a to-be-bonded third die and a fourth die on the wafer, according to the third deviation value.

The bonding assembly is further configured to bond the third die and the fourth die which have been adjusted according to the calibration parameters.

In some embodiments, the wafer stage may be further configured to drive, according to the calibration parameters, the carried wafer to move relative to the picking surface, so that the third die and the fourth die are located at to-be-bonded positions.

Embodiments of the present disclosure provide a bonding system and a bonding compensation method. According to the bonding compensation method, the calibration parameters may be determined according to the third deviation value between positions of the first die and the second die which have been bonded, and accuracy compensation of coordinate deviation value and/or angle deviation value is performed on the to-be-bonded third die and the fourth die on the wafer, which may improve efficiency and accuracy of die to wafer bonding.

### BRIEF DESCRIPTION OF THE DRAWINGS

One or more embodiments are exemplarily explained by pictures in the drawings corresponding thereto. Unless otherwise stated, the pictures in the drawings do not constitute scale limitation.
FIG. 1 is a schematic view of die to wafer according to an embodiment of the present disclosure.
FIG. 2 is a schematic flowchart of a bonding compensation method according to an embodiment of the present disclosure.
FIG. 3A is a first schematic view of a structure corresponding to a bonding compensation method according to an embodiment of the present disclosure.
FIG. 3B is a second schematic view of a structure corresponding to a bonding compensation method according to an embodiment of the present disclosure.
FIG. 3C is a third schematic view of a structure corresponding to a bonding compensation method according to an embodiment of the present disclosure.
FIG. 3D is a fourth schematic view of a structure corresponding to a bonding compensation method according to an embodiment of the present disclosure.
FIG. 3E is a fifth schematic view of a structure corresponding to a bonding compensation method according to an embodiment of the present disclosure.
FIG. 4A is a sixth schematic view of a structure corresponding to a bonding compensation method according to an embodiment of the present disclosure.
FIG. 4B is a seventh schematic view of a structure corresponding to a bonding compensation method according to an embodiment of the present disclosure.
FIG. 5 is an eighth schematic view of a structure corresponding to a bonding compensation method according to an embodiment of the present disclosure.
FIG. 6A is a first schematic view of a bonding system according to an embodiment of the present disclosure.
FIG. 6B is a second schematic view of a bonding system according to an embodiment of the present disclosure.

### Reference numerals:

10 - Die; 20 - Wafer; 11 - First die; 110 - First positioning mark; 301 - Bonding head; 302 - First optical path; 21 - Second die; 210 - Second positioning mark; 303 - Wafer stage; 304 - First alignment assembly; 305 - Second alignment assembly; 306 - Third alignment assembly; 31 - Third die; 41 - Fourth die; 11', 21' - Die; 301a - Top surface; 301b - Picking surface; 302a - First end of first optical path; 302b - Second end of first optical path; 3021 - First reflector; 3041 - Aligner; 3042 - Second optical path; 307 - Fixation unit; 308 - Mobile unit; 309 - Calibration assembly.

### DETAILED DESCRIPTION

Technical solutions of the present disclosure will be further described in detail below in combination with the drawings and embodiments. Although exemplary implementations of the present disclosure are shown in the drawings, it should be understood that the present disclosure may be implemented in various forms and should not be limited by implementations described here. Instead, these implementations are provided to understand the present disclosure more thoroughly and convey the scope of the present disclosure to those skilled in the art completely.

In the following paragraphs, the present disclosure is described more specifically by way of example with reference to the drawings. According to the following descriptions and claims, advantages and features of the present disclosure will be clearer. It is to be noted that the drawings are in a very simplified form and use imprecise scales, which are only intended to assistant to explain the embodiments of the present disclosure conveniently and clearly.

In the embodiments of the present disclosure, terms "first", "second" or the like are intended to distinguish similar objects, rather than describing a specific order or sequence.

It is to be noted that the technical solutions recorded in the embodiments of the present disclosure may be arbitrarily combined with each other without conflict.

In the field of semiconductor manufacturing, as a rising bonding technology, hybrid bonding gradually transfers a bonding process from back end packaging to front end wafer manufacturing, and has many advantages over bump bonding of the back end packaging, such as simple process, smaller size, higher I/O density, non-existence of a problem of electro-migration failure, or the like. Hybrid bonding is more suitable to manufacture chips with high energy consumption and high bandwidth, such as High Bandwidth Memory (HBM), Neural-network Processing Unit (NPU), Artificial Intelligence (AI) chips, or the like.

As to a hybrid bonding technology, when accuracy of hardware (such as a wafer stage, a bonding head, or the like) itself reaches a bottleneck, it is an effective way to further improve processing accuracy by way of Run to Run (R2R).

R2R method for wafer to wafer hybrid bonding is relatively simple, that is, it detects accuracy data of several bonded wafers, and deduces, through algorithm fitting, position accuracy data to be compensated before a next wafer bonding, and then implements accuracy compensation to improve bonding accuracy. Therefore, it is of great significance to apply the R2R method to die to wafer hybrid bonding.

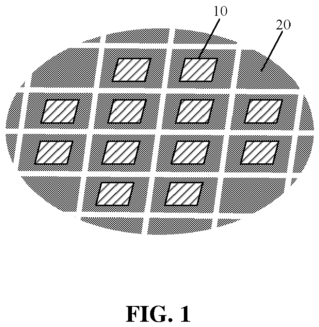

Exemplarily, FIG. 1 shows a schematic view of die to wafer hybrid bonding. With reference to FIG. 1, multiple dies 10 are sequentially bonded to corresponding positions on a wafer 20. The multiple dies 10 may be of the same type, that is, all of them are memory chips, control chips or other chips of the same type. In this way, a plasma activation operation may be performed uniformly before a hybrid bonding process is performed.

It may be understood that FIG. 1 shows only a part of a bonding structure from the die 10 to the wafer 20. In an actual bonding operation, the number of dies 10 may be much larger than that of dies shown in FIG. 1. That is, hundreds of dies 10 correspond to a wafer 20. By way of bonding all of them and then detecting, efficiency is very low, and dies 10 with abnormal bonding (such as occurence of displacement deviation or die damage) may not be reworked timely, leading to failure of products.

In view of this, the embodiments of the present disclosure provide a bonding system and a bonding compensation method.

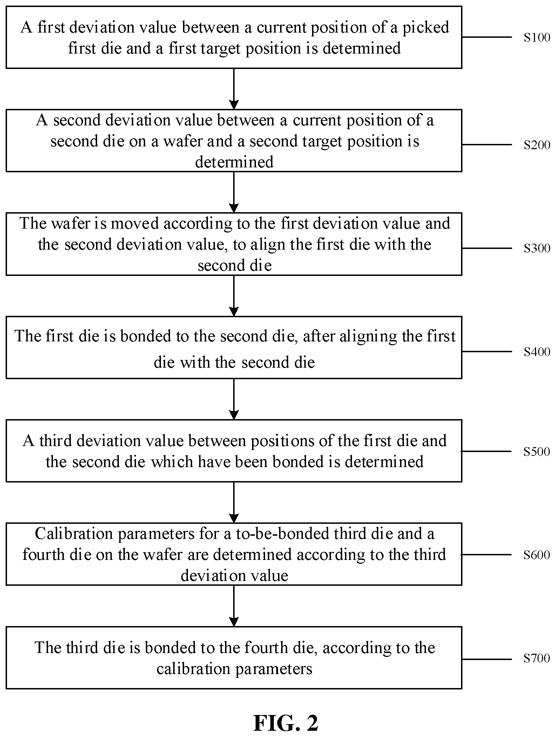

According to a first aspect, with reference to FIG. 2, an embodiment of the present disclosure provides a bonding compensation method. The bonding compensation method includes the following operations S100 - S700.

In operation S100, a first deviation value between a current position of a picked first die and a first target position is determined.

In operation S200, a second deviation value between a current position of a second die on a wafer and a second target position is determined.

In operation S300, the wafer is moved according to the first deviation value and the second deviation value, to align the first die with the second die.

In operation S400, the first die is bonded to the second die, after aligning the first die with the second die.

In operation S500, a third deviation value between positions of the first die and the second die which have been bonded is determined.

In operation S600, calibration parameters for a to-be-bonded third die and a fourth die on the wafer are determined according to the third deviation value.

In operation S700, the third die is bonded to the fourth die, according to the calibration parameters.

In the embodiment of the present disclosure, to-be-bonded dies (such as the first die and the third die) may be picked by using the bonding head through vacuum adsorption or electrostatic adsorption. The picked to-be-bonded dies include semiconductor chips, such as memory chips, communication chips, Artificial Intelligence (AI) chips, light-emitting diode (LED) chips, sensor chips, display chips, or the like.

On the other hand, dies may be absorbed by using a wafer stage. Here, the wafer stage may include a chuck, such as an electrostatic chuck (ESC chuck) or the like. The wafer further includes multiple to-be-bonded dies (such as the second die and the fourth die), here each of the to-be-bonded dies on the wafer includes a substrate and functional structures (such as a storage array or a functional circuit) on the substrate, and a cutting channel is arranged between two adjacent to-be-bonded dies.

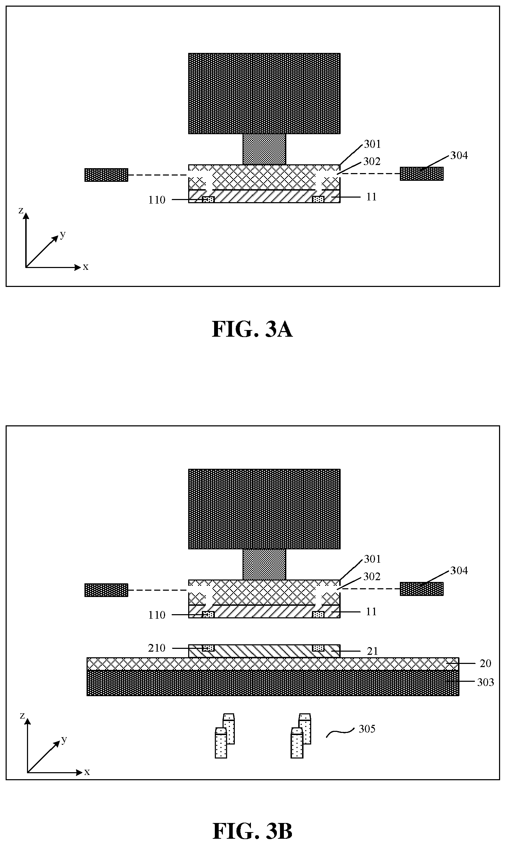

In operation S100, with reference to FIG. 3A, a first alignment assembly 304 may transmit a detection optical signal when a bonding head 301 picks a first die 11 and is located at a first position, the detection optical signal is transmitted to a positioning mark 110 of the first die 11 through a first optical path 302 within the bonding head 301, to form a reflection optical signal, the reflection optical signal is transmitted back to the first alignment assembly 304 through the first optical path 302.

Furthermore, after receiving the reflection optical signal, the first alignment assembly 304 may determine the first deviation value (Δx_{T}, Δy_{T}) between the current position (x₁, y₁) of the first die 11 and the first target position (x₀, y₀) according to the reflection optical signal, here Δx_{T} = x₁ - x₀, Δy_{T} = y₁ - y₀.

It is to be noted that the first deviation value is a displacement deviation in a horizontal direction, and values Δx_{T} and Δy_{T} does not represent coordinate values, instead, represent distances between coordinate points of the first die 11 on x-axis and y-axis respectively and coordinate points corresponding to the first target position, and the values may be positive or negative results, here "positive" and "negative" represent a direction. For example, when Δx_{T} in the first deviation value is a positive result, it means that coordinate of the first die 11 on the x-axis is located in a positive direction of the first target position along the x-axis, with a distance of an absolute value of Δx_{T}; vice versa, when Δx_{T} in the first deviation value is a negative result, it means that coordinate of the first die 11 on the x-axis is located in a negative direction of the first target position along the x-axis, with a distance of an absolute value of Δx_{T} too.

In operation S200, after determining the first deviation value, a wafer 20 is transmitted to a wafer stage 303, the second deviation value may be determined by using a second alignment assembly 305. Similarly, the second alignment assembly 305 may transmit a detection optical signal, the detection optical signal is transmitted to a positioning mark 210 of a second die 21 through the wafer stage 303 and the wafer 20, to form a reflection optical signal, the reflection optical signal is transmitted back to the second alignment assembly 305 through the wafer 20 and the wafer stage 303.

Furthermore, after receiving the reflection optical signal, the second alignment assembly 305 may determine the second deviation value (Δx_{B}, Δy_{B}) between the current position (x₂, y₂) of the second die 21 on the wafer 20 and the second target position (x₀', y₀') according to the reflection optical signal, here Δx_{B} = x₂ - x₀', Δy_{T} = y₂ - y₀'. It may be understood that the second deviation value is also a displacement deviation in the horizontal direction, and values Δx_{B} and Δy_{B} have meanings the same as those of corresponding values in the first deviation value.

It is to be noted that the first target position and the second target position have the same position in the horizontal direction, while have different positions in a vertical direction, that is, x₀ is the same as x₀', y₀ is the same as y₀', and the first target position and the second target position have different coordinates in z direction. Different reference numerals are only intended to facilitate distinction between the first target position and the second target position, and are not intended to limit the present disclosure.

In operation S300, a displacement deviation between the first die 11 and the second die 21 may be determined to be (Δx_{T} - Δx_{B}, Δy_{T} - Δy_{B}) according to the first deviation value and the second deviation value. The bonding head 300 may be kept fixed (that is, the first die 11 is kept fixed). The wafer stage 303 drives the wafer 20 to move by (Δx_{T} - Δx_{B}, Δy_{T} - Δy_{B}) horizontally according to the displacement deviation, so that the first die 11 is aligned with the second die 21, that is, positions of the first die 11 and the second die 21 in the horizontal direction are the same.

Here, a direction in which the wafer stage 303 drives the wafer 20 to move may be determined according to a positive or negative value of Δx_{T} - Δx_{B}. For example, when Δx_{T} - Δx_{B} is a negative value, the wafer stage 303 drives the wafer 20 to move in a negative direction of x-axis, and a movement distance is an absolute value of (Δx_{T} - Δx_{B}). When Δx_{T} - Δx_{B} is a positive value, the wafer stage 303 drives the wafer 20 to move in a positive direction of x-axis, and a movement distance is (Δx_{T} - Δx_{B}).

Similarly, a direction in which the wafer stage 303 drives the wafer 20 to move may be determined according to a positive or negative value of Δy_{T} - Δy_{B}. For example, when Δy_{T} - Δy_{B} is a negative value, the wafer stage 303 drives the wafer 20 to move in a negative direction of y-axis, and a movement distance is an absolute value of (Δy_{T} - Δy_{B}). When Δy_{T} - Δy_{B} is a positive value, the wafer stage 303 drives the wafer 20 to move in a positive direction of y-axis, and a movement distance is (Δy_{T} - Δy_{B}).

In this example, the wafer stage 303 drives the wafer 20 to move, however, in other examples, the bonding assembly may move relative to the wafer 20 to align the first die 11 with the second die 21. For example, the wafer 20 may be kept fixed (that is, the second die 21 is kept fixed), and the bonding assembly moves by (Δx_{T} - Δx_{B}, Δy_{T} - Δy_{B}) horizontally according to the displacement deviation, so that the first die 11 is aligned with the second die 21.

Here, a direction in which the bonding assembly moves may be determined according to a positive or negative value of Δx_{T} - Δx_{B}. For example, when Δx_{T} - Δx_{B} is a negative value, the bonding assembly moves in a positive direction of x-axis, and a movement distance is an absolute value of (Δx_{T} - Δx_{B}). When Δx_{T} - Δx_{B} is a positive value, the bonding assembly moves in a negative direction of x-axis, and a movement distance is (Δx_{T} - Δx_{B}).

Similarly, a direction in which the bonding assembly moves may be determined according to a positive or negative value of Δy_{T} - Δy_{B}. For example, when Δy_{T} - Δy_{B} is a negative value, the bonding assembly moves in a positive direction of y-axis, and a movement distance is an absolute value of (Δy_{T} - Δy_{B}). When Δy_{T} - Δy_{B} is a positive value, the bonding assembly moves in a negative direction of y-axis, and a movement distance is (Δy_{T} - Δy_{B}).

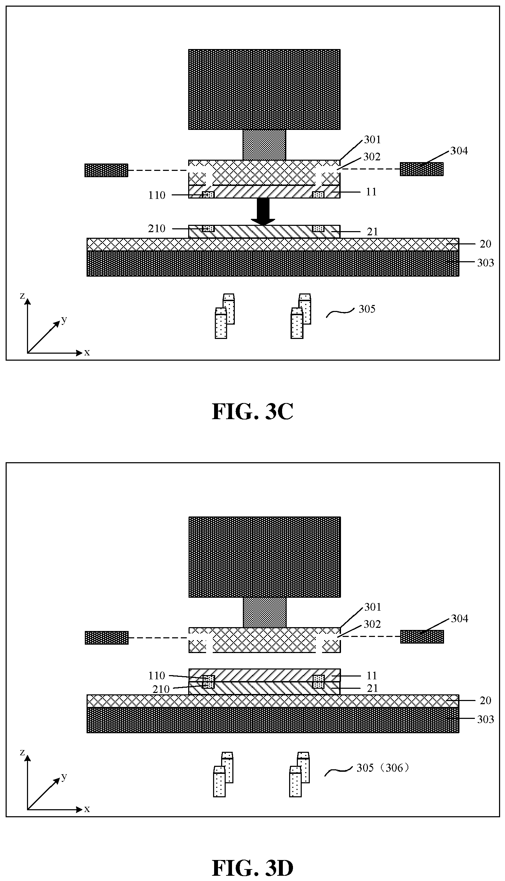

In operation S400, with reference to FIG. 3C, after aligning the first die 11 with the second die 21, the bonding head 301 may pick the first die 11 to vertically move downward in a z-axis direction (as shown by an arrow in the figure), to perform the bonding operation.

It is to be noted that even though the first die 11 is aligned with the second die 21 according to the first deviation value and the second deviation value, a displacement deviation may be generated when the bonding head 301 vertically moves downward to bond the first die 11. Therefore, the third deviation value is generated between positions of the first die 11 and the second die 21 which have been bonded.

In operation S500, with reference to FIG. 3D, after bonding the first die 11 to the second die 21, the optical signal may be visualized as a projection image through optical alignment, and the third deviation value between the first die 11 and the second die 21 may be determined according to coordinates on the image, here the third deviation value is a horizontal displacement deviation.

Exemplarily, the first die 11 may include the first positioning mark 110, and the second die 21 may include the second positioning mark 210. Here, each of the first positioning mark 110 and the second positioning mark 210 may be a patterned structure and may be made of a metal material or another reflective material, so that the detection optical signal forms a reflection optical signal at the positioning marks.

Specifically, the detection optical signal may be transmitted by an optical transmitter such as a LED, a laser diode, or the like, and the reflection optical signal may be received by a photodetector such as a photodiode, a photomultiplier tube, or the like. Furthermore, the photodetector may be connected to an image sensor configured to convert the received reflection optical signal into a visual projection image, according to which the third deviation value between positions of the first die 11 and the second die 21 may be determined.

With reference to FIG. 3D, the optical transmitter and the photodetector may also be integrated in the same electronic device, such as the second alignment assembly 305 and a third alignment assembly 306. Here, the second alignment assembly 305 and the third alignment assembly 306 may be a same set of alignment assemblies, or two independent sets of alignment assemblies with the same structure (number of lenses, spacing between lenses, positions of lenses, or the like). Therefore functions of the second alignment assembly 305 and the third alignment assembly 306 may be replaced by each other.

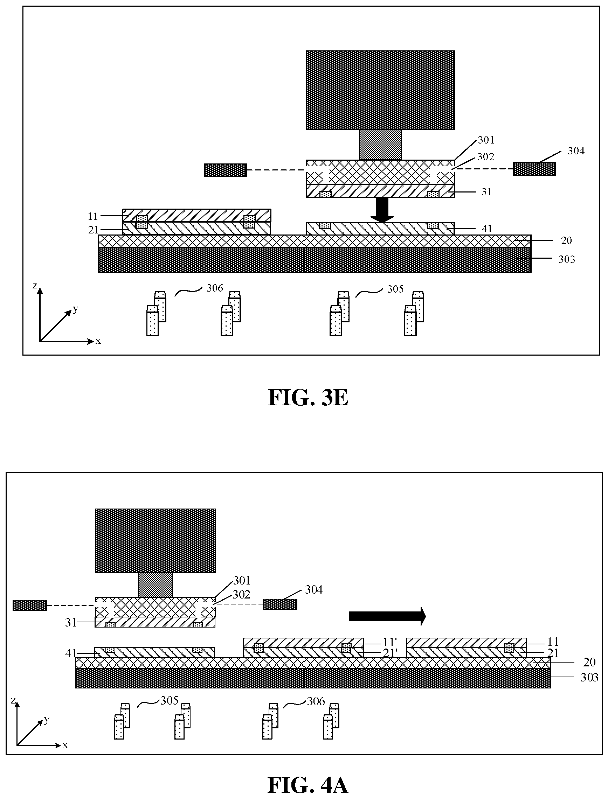

In operation S600, with reference to FIG. 3E, after bonding the first die 11 to the second die 21, the bonding head 301 continues to pick a third die 31 to perform an operation of bonding it to a corresponding fourth die 41 on the wafer 20. Before performing alignment and bonding operations on the third die 31 and the fourth die 41, calibration parameters may be determined according to the third deviation value between the first die 11 and the second die 21.

Exemplarily, the third deviation value may be a coordinate deviation value obtained from the projection image, for example, a coordinate deviation value (Δxₙ, Δyₙ) between a projection coordinate (x₁₁, y₁₁) of center of the first positioning mark 110 on the first die 11 and a projection coordinate (x₂₁, y₂₁) of center of the second positioning mark 210 on the second die 21, here Δxₙ = x₁₁-x₂₁, Δyₙ=y₁₁-y₂₁.

It is to be noted that values of Δxₙ and Δyₙ are calculated with a projection coordinate of center of the first positioning mark 110 taken as a reference point, and represent a distance between the projection coordinate of center of the second positioning mark 210 and the projection coordinate of center of the first positioning mark 110. The values may be positive or negative results, here "positive" and "negative" represent a direction. For example, when Δxₙ is a positive result, it means that with respect to the first die 11, the second die 21 is located in a negative direction of the first die 11 along the x-axis, with a distance of Δxₙ. When Δxₙ is a negative result, it means that with respect to the first die 11, the second die 21 is located in a positive direction of the first die 11 along the x-axis, with a distance of an absolute value of Δxₙ. Similarly, Δyₙ represents the same meaning as Δxₙ.

It may be understood that when the values are calculated with a projection coordinate of center of the second positioning mark 210 taken as a reference point, the coordinate deviation value is denoted by (Δxₙ', Δyₙ'), here Δxₙ' = x₂₁ - x₁₁, Δyₙ' = y₂₁ - y₁₁, the present disclosure does not make too much limitation thereto.

In some other embodiments, the third deviation value may also be an angle deviation value. For example, since the bonding head 301 rotates along an axis when the bonding head 301 vertically moves downward, a bonding surface of the first die 11 rotates by a rotation offset of a certain angle in the horizontal direction, relative to a bonding surface of the second die 21.

In the embodiment of the present disclosure, the calibration parameters may be determined by data fitting (such as linear fitting, polynomial fitting, or the like) or other ways, according to the third deviation value. Here, the calibration parameter correspond to the third deviation value, and may be the coordinate deviation value and/or the angle deviation value.

Exemplarily, the third deviation value between the first die 11 and the second die 21 includes the coordinate deviation value and/or the angle deviation value, an offset in x direction is marked as Δx, an offset in y direction is marked as Δy, and an angle offset is marked as Δθ. A fitting model is established by linear fitting, and the calibration parameter may be determined as (Δx', Δy', Δθ'), and then corresponding accuracy compensations are (Δx' = a₁ * Δx + A), (Δy' = b₁ * Δy + B) and (Δθ' = s₁ * Δθ + S) respectively, here a₁, b₁ and s₁ are fitting coefficients respectively, and A, B and S are fitting constants respectively.

It may be understood that the calibration parameters may also be determined according to third deviation values of multiple dies which have been bonded, and then corresponding fitting coefficients should be increased too, the present disclosure does not make too much limitation thereto.

In operation S700, with reference to FIG. 3E, the bonding head 301 picks the third die 31 and places it at a position opposite to the fourth die 41, and performs accuracy compensation of the coordinate deviation value and/or the angle deviation value according to the calibration parameters, and then vertically moves downward along the z-axis direction (as shown by an arrow in the figure) to bonds the third die 31 to the fourth die 41.

According to the bonding compensation method provided by the embodiments of the present disclosure, the calibration parameters may be determined according to the third deviation value between positions of the first die 11 and the second die 21 which have been bonded, and accuracy compensation of coordinate deviation value and/or angle deviation value is performed on the to-be-bonded third die 31 and the fourth die 41 on the wafer, which may improve efficiency and accuracy of die to wafer bonding.

In some embodiments, the operation of bonding the third die to the fourth die, according to the calibration parameters may include the following operations.

The wafer is moved based on the calibration parameters, so that the third die and the fourth die are located at to-be-bonded positions.

The third die is bonded to the fourth die.

In the embodiments of the present disclosure, the alignment operation is performed by moving the wafer stage 303. Specifically, the wafer stage 303 is configured to drive the carried wafer 20 to move according to a horizontal offset of the first deviation value and the second deviation value, to align the second die 21 with the first die 11. This is because in the embodiments of the present disclosure, the bonding head 301 has a small size, is easy to fluctuate, and may incline relative to a horizontal plane, leading to inclination of the die picked by the bonding head 301, affecting alignment and reducing bonding accuracy. Instead, the wafer 20 has a size greater than that of the bonding head 301, there is a small probability of a bonding surface of the wafer 20 fluctuating in the horizontal plane during the stage 303 driving the wafer 20 to move, that is, the second die 21 bonded with the first die 11 is more horizontal, which is conducive to improving accuracy of die to wafer bonding.

In the embodiments of the present disclosure, the bonding operation may be performed by moving the bonding head 301. Specifically, the bonding head 301 may be driven by using a corresponding bonding assembly according to a vertical distance between the first target position and the second target position, to vertically move downward to bond the first die 11 picked by the bonding head 301 to the second die 21 on the wafer 20. This is because the bonding head 301 has small size and mass compared with the wafer stage 303, the bonding head 301 has small inertia and may move with fast speed and high frequency, which is conducive to improving efficiency of die to wafer bonding.

Exemplarily, with reference to FIG. 3E, the third alignment assembly 306 may be located at a position adjacent to the second alignment assembly 305, and after bonding the first 11 to the second die 21, the wafer stage 303 may drive the wafer 20 to move relative to the third alignment assembly 306m to measure the third deviation value between positions of the first die 11 and the second die 21.

It is to be noted that a distance between dies on the wafer 20 may be known, for example, there is a preset distance between the second die 21 and the fourth die 41. In this way, a distance between the second alignment assembly 305 and the third alignment assembly 306 may be the same as the distance between dies, so that after moving the dies (the first die 11 and the second die 21) which have been bonded, a displacement deviation value between a position of a next to-be-bonded die (the fourth die 41) and the second target position determined by the second alignment assembly 305 is the same, reducing operations.

In the embodiments of the present disclosure, when the third deviation value is determined by the third alignment assembly 305, the bonding head 301 may pick the third die 31 and places it at a position opposite to the fourth die 41. After determining the third deviation value, corresponding calibration parameters may be obtained according to the third deviation value. The bonding head 301 moves the wafer stage 303 based on the calibration parameters, to drive the wafer 20, so that the third die 31 and the fourth die 41 are located at to-be-bonded positions.

It is to be noted that the to-be-bonded positions are positions after accuracy compensation of the third die 31 and/or the fourth die 41 is performed based on the calibration parameters.

Exemplarily, when the first die 11 is positively bonded to the second die 21, that is, when the third deviation value determined by the bonding operation after aligning the first die 11 with the second die 21 is zero, then the to-be-bonded positions of the third die 31 and the fourth die 41 is positions after alignment. When the third deviation value after bonding the first die 11 to the second die 21 is not zero, the to-be-bonded positions of the third die 31 and the fourth die 41 are positions after accuracy compensation is performed on relative alignment positions.

Furthermore, the operation of bonding the third die 31 to the fourth die 41 is performed at the to-be-bonded positions, which may reduce a coordinate deviation value and/or an angle deviation value generated when the bonding head 301 vertically moves downward, improving efficiency and accuracy of die to wafer bonding.

In some embodiments, the operation of moving the wafer based on the calibration parameters may include the following operations.

A fourth deviation value between a current position of the third die which has been picked and a third target position is determined.

A fifth deviation value between a current position of the fourth die on the wafer and a fourth target position is determined.

The wafer is moved according to the fourth deviation value, the fifth deviation value and the calibration parameters, so that the third die and the fourth die are located at the to-be-bonded positions.

In the embodiments of the present disclosure, before die to wafer bonding, a standard die may be used to calibrate positions of the first alignment assembly 304 and the second alignment assembly 305, to determine the first target position and the second target position. Here, the first target position represents a position of the standard die after calibration, and coordinate in the horizontal direction is marked as (x₀, y₀); a position with a preset distance from the first target position in the vertical direction is marked as the second target position, coordinate of the second target position in the horizontal direction is marked as (x₀', y₀'), here the preset distance is greater than 0. It may be understood that although the first target position and the second target position have the same position in the horizontal direction (x and y directions), they are not the same position in a 3D space, that is, the first target position and the second target position have different positions in the vertical direction (z direction).

When the first die 11 is located at the first target position, and the second die 21 is located at the second target position, it may be considered that the first die 11 is aligned with the second die 21. That is, a projection of the first die 11 on the wafer stage overlaps with the second die 21 in the vertical direction.

It is to be noted that the current position of the first die 11 represents an actual position of the first die 11 when the bonding assembly is adjusted to the first position, and may have a deviation with respect to the first target position. The current position of the second die 21 represents an actual position of the second die 21 when the wafer 20 is placed on the wafer stage 303 and a die required to be bonded on the wafer 20 is determined to be the second die 21, and may have a deviation with respect to the second target position.

When the current position of the first die 11 is the first target position and the current position of the second die 21 is the second target position, each of the first deviation value and the second deviation value is 0. Accurate alignment and bonding between the first die 11 and the second die 21 may be implemented by the bonding head 301 vertically moving downward.

It is to be noted that in the embodiments of the present disclosure, the first target position corresponding to the first die 11 is the same as the third target position corresponding to the third die 31, and the second target position corresponding to the second die 21 is the same as the fourth target position corresponding to the fourth die 41.

Exemplarily, a current position of the third die 31 may continue to be measured by the first alignment assembly 304. Specifically, the first alignment assembly 304 may transmit a detection optical signal, the detection optical signal is transmitted to a positioning mark of the third die 31 through the first optical path 302 within the bonding head 301, to form a reflection optical signal, the reflection optical signal is transmitted back to the first alignment assembly 304 through the first optical path 302.

Furthermore, after receiving the reflection optical signal, the first alignment assembly 304 may determine the fourth deviation value (Δx_{Q}, Δy_{Q}) between the current position (x₃, y₃) of the third die 31 and the third target position (x₀, y₀) according to the reflection optical signal, here Δx_{Q} = x₃ - x₀, Δy_{Q} = y₃ - y₀.

Exemplarily, a distance between dies on the wafer 20 may be known, that is, there is a preset distance between the fourth die 41 and the second die 21. the fifth deviation value (Δx_{P}, Δy_{P}) between the current position (x₄, y₄) of the fourth die 41 and the fourth target position (x₀', y₀') may be determined according to the second deviation value between the second die 21 and the second target position, here Δx_{P} = x₄ - x₀', Δy_{P} = y₄ - y₀'. It may be understood that the fifth deviation value (Δx_{P}, Δy_{P}) may be the same as coordinate parameters corresponding to the second deviation value (Δx_{B}, Δy_{B}).

Similarly, the third target position and the fourth target position have the same position in the horizontal direction, while have different positions in the vertical direction, that is, x₀ is the same as x₀', y₀ is the same as y₀', and the third target position and the fourth target position have different coordinates in z direction. Different reference numerals are only intended to facilitate distinction between the third target position and the fourth target position, and are not intended to limit the present disclosure.

Furthermore, in the embodiments of the present disclosure, the calibration parameters may be determined according to the third deviation value between the first die 11 and the second die 21, and the wafer stage 303 may be moved to drive the wafer 20, to place the third die 31 and the fourth die 41 at the to-be-bonded positions. Here, the to-be-bonded positions are positions after performing accuracy compensation according to the fourth deviation value, the fifth deviation value and the calibration parameters.

In some embodiments, the operation of moving the wafer according to the fourth deviation value, the fifth deviation value and the calibration parameters, so that the third die and the fourth die are located at the to-be-bonded positions may include the following operations.

At least the fourth deviation value or the fifth deviation value is calibrated based on the calibration parameters.

The wafer is moved according to the fourth deviation value and the fifth deviation value which have been calibrated, so that the third die and the fourth die are located at the to-be-bonded positions.

Exemplarily, the third deviation value between the first die 11 and the second die 21 may be the coordinate deviation value, an offset in x direction is marked as Δxₙ', and an offset in y direction is marked as Δyₙ'. The calibration parameter determined by linear fitting is (Δxₕ, Δyₕ), and corresponding accuracy compensations are (Δxₕ = a₁' ^{∗} Δxₙ' + A') and (Δyₕ = b₁' ^{∗} Δyₙ' + B'), here a₁' and b₁' are fitting coefficients, and A' and B' are fitting constants.

At least the fourth deviation value (Δx_{Q}, Δy_{Q}) or the fifth deviation value (Δx_{P}, Δy_{P}) may be calibrated directly based on the calibration parameters.

Exemplarily, when the fourth deviation value is calibrated, the fourth deviation value with accuracy compensation is (Δx_{Q} + Δxₕ, Δy_{Q} + Δyₕ). When the fifth deviation value is calibrated, the fifth deviation value with accuracy compensation is (Δx_{P} + Δxₕ, Δy_{P}+ Δyₕ). When the fourth deviation value and the fifth deviation value are calibrated, the fourth deviation value with accuracy compensation is (Δx_{Q} + Δxₕ₁, Δy_{Q} + Δyₕ₁), and the fifth deviation value with accuracy compensation is (Δx_{P} + Δxₕ₂, Δy_{P} + Δyₕ₂), here Δxₕ = Δxₕ₁ + Δxₕ₂, Δyₕ = Δyₕ₁ + Δyₕ₂.

Furthermore, the wafer stage 303 may drive the wafer 20 according to at least the fourth deviation value or the fifth deviation value which have been calibrated, so that the fourth die 41 is arranged at a to-be-bonded position with the third die 31.

In the embodiments of the present disclosure, at least the fourth deviation value or the fifth deviation value may be calibrated directly, so that the third die 31 and the fourth die 41 are located at the to-be-bonded positions. In this way, alignment operations are reduced, not only bonding efficiency may be improved, but also bonding accuracy may be improved.

In some embodiments, the operation of moving the wafer based on the calibration parameters, so that the third die and the fourth die are located at to-be-bonded positions may include the following operations.

The wafer is moved to align the third die with the fourth die.

A compensation offset is determined based on the calibration parameters.

The wafer is moved according to the compensation offset, so that the third die and the fourth die are located at the to-be-bonded positions.

Exemplarily, the third deviation value being the coordinate deviation value is taken as an example, an offset in x direction is marked as Δxₙ", and an offset in y direction is marked as Δyₙ". The calibration parameter determined by linear fitting is (Δxₖ, Δyₖ).

A compensation offset after aligning the third die 31 with the fourth die 41 may be determined based on the calibration parameters. That is, a compensation offset in x direction is (Δxₖ = a₁" ^{∗} Δxₙ" + A"), and a compensation offset in y direction is (Δyₖ = b₁" ^{∗} Δyₙ" + B"), here a₁" and b₁" are fitting coefficients, and A" and B" are fitting constants.

Furthermore, since the wafer stage 303 is driven to move in the embodiments of the present disclosure, the compensation offset may be configured to calibrate the fourth die 41. Specifically, when Δxₖ is a positive value, the wafer 20 is driven to move in a positive direction of x-axis, and a movement distance is Δxₖ. When Δxₖ is a negative value, the wafer 20 is driven to move in a negative direction of x-axis, and a movement distance is an absolute value of Δxₖ. The accuracy compensation in y direction is the same as that in x direction, when Δyₖ is a positive value, the wafer 20 is driven to move in a positive direction of y-axis, and a movement distance is Δyₖ. When Δyₖ is a negative value, the wafer 20 is driven to move in a negative direction of y-axis, and a movement distance is an absolute value of Δyₖ.

It may be understood that in some embodiments, a compensation offset of the third die 31 may be determined based on the calibration parameters. Correspondingly, the wafer stage 303 may be fixed, and the bonding head 301 may be driven to calibrate the third die 31. In some other embodiments, both the wafer stage 303 and the bonding head 301 may move relatively, thus compensation offsets of the third die 31 and the fourth die 41 may be determined based on the calibration parameters, the present disclosure does not make too much limitation thereto.

Therefore, in the embodiments of the present disclosure, the third die 31 may be aligned with the fourth die 41 before performing accuracy compensation thereon, so that the third die 31 and the fourth die 41 are located at the to-be-bonded positions. In this way, bonding accuracy may also be improved.

In some embodiments, the operation of moving the wafer to align the third die with the fourth die may include the following operations.

A fourth deviation value between a current position of the third die which has been picked and a third target position is determined.

A fifth deviation value between a current position of the fourth die on the wafer and a fourth target position is determined.

The wafer is moved according to the fourth deviation value and the fifth deviation value, to align the third die with the fourth die.

In the embodiments of the present disclosure, the alignment operation of the third die 31 and the fourth die 41 may have the same operations as those of the alignment operation of the first die 11 and the second die 21, so that unity of processes may be kept, displacement deviations are reduced, thereby improving bonding accuracy.

In some other embodiments, the fifth deviation value between the current position of the fourth die 41 and the fourth target position may be determined based on the second deviation value between the second die 21 and the second target position, so that alignment operations are reduced thereby improving bonding accuracy.

In some embodiments, the operation of determining the third deviation value between positions of the first die and the second die which have been bonded may include the following operations.

At least two third deviation values corresponding to at least two first dies and at least two second dies which have been bonded are determined.

The operation of determining calibration parameters for the to-be-bonded third die and the fourth die on the wafer, according to the third deviation value may include the following operations.

The at least two third deviation values are fitted to obtain a fitting function.

The calibration parameters are determined according to the fitting function.

In the embodiments of the present disclosure, the calibration parameters for the to-be-bonded third die 31 and the fourth die 41 may be determined by data of at least two third deviation values. Furthermore, fitting of the at least two third deviation values may include one or more of linear fitting, polynomial fitting, or other fitting ways.

Exemplarily, the following three third deviation values are fitted according to a linear fitting model: (Δx₁, Δy₁, Δθ₁), (Δx₂, Δy₂, Δθ₂) and (Δx₃, Δy₃, Δθ₃). Here, Δx₁,) Δx₂ and Δx₃ represent coordinate deviation values in the x-axis, Δy₁, Δy₂ and Δy₃ represent coordinate deviation values in the y-axis, Δθ₁, Δθ₂ and Δθ₃ represent angle deviation values.

Correspondingly, a fitting function f (Δx₄, Δy₄, Δθ₄) may be obtained after linear fitting, here corresponding values in the fitting function f represent corresponding calibration parameters. That is, Δx₄ represents a calibration parameter in the x-axis, Δy₄ represents a calibration parameter in the y-axis, Δθ₄ represents a calibration parameter in angle. Specifically, the calibration parameters are Δx₄ = A₁ ^{∗} Δx₁ + A₂ ^{∗} Δx₂ + A₃ ^{∗} Δx₃ + a, Δy₄ = B, ^{∗} Δy₁ + B₂ ^{∗} Δy₂+ B₃ ^{∗} Δy₃ + b, Δθ₄ = S₁ ^{∗} Δθ₁ + S₂ ^{∗} Δθ₂ + S₃ ^{∗} Δθ₃ + s, respectively. Here, A₁, A₂, A₃, B₁, B₂, B₃, S₁, S₂ and S₃ are fitting coefficients of Δx₁, Δx₂, Δx₃, Δy₁, Δy₂, Δy₃, Δθ₁, Δθ₂ and Δθ₃ respectively, and a, b and s are fitting constants.

It may be understood that in some other embodiments, the calibration parameters may be determined by at least two third deviation values, and a corresponding standard fitting function f (Δxₙ, Δyₙ, Δθₙ) may be obtained. Here, Δxₙ = A₁ ^{∗} Δx₁ + A₂ ^{∗} Δx₂+...+ Aₙ₋₁ ^{∗} Δxₙ₋₁ + a, Δyₙ = B₁ ^{∗} Δy₁ + B₂ ^{∗} Δy₂+...+ Bₙ₋₁ ^{∗} Δyₙ₋₁ + b, Δθₙ= S₁ ^{∗} Δθ₁ + S₂ ^{∗} Δθ₂ +...+ Sₙ₋₁ ^{∗} Δθₙ₋₁ + s.

Therefore, in the embodiments of the present disclosure, the calibration parameters may be determined by data fitting of at least two third deviation values, so that reliability of the calibration parameters may be improved, thereby improving bonding accuracy.

In some embodiments, the operation of determining at least two third deviation values corresponding to at least two first dies and at least two second dies which have been bonded may include the following operations.

At least two adjacent dies on the wafer are determined as second dies, here dies to be bonded after the at least two second dies on the wafer are fourth dies.

The at least two third deviation values are determined, after bonding the at least two second dies to first dies corresponding to the second dies.

With reference to FIG. 1, multiple dies 10 are sequentially bonded to corresponding positions on the wafer 20. When a current die, i.e., the third die 31, is bonded, the wafer 20 may include multiple dies 10 which have been bonded. Here, the dies 10 which have been bonded may be the second dies 21, and in the embodiments of the present disclosure, multiple dies 21 which have been bonded may be arranged adjacent to each other.

Correspondingly, a die on the wafer 20 to be bonded with a next to-be-picked die, i.e., the third die 31 is the fourth die 41. Furthermore, multiple second dies 21 and first dies 11 which have been bonded may be detected by using the second alignment assembly 305 and/or the third alignment assembly 306, to determine third deviation values corresponding thereto.

In the embodiments of the present disclosure, at least two third deviation values corresponding to at least two adjacent second dies may be determined during bonding the third die 11 to the fourth die 41, and fitting may be performed by taking the third deviation values as basic data, so that the calibration parameters may be obtained easily and quickly, which is convenient to bond subsequent to-be-bonded dies based on the calibration parameters, improving bonding efficiency.

In some embodiments, the operation of determining calibration parameters for the to-be-bonded third die and the fourth die on the wafer, according to the third deviation value may include the following operations.

The calibration parameters are determined according to the at least two third deviation values, before bonding the fourth dies to be bonded after the second dies to respective third dies.

In the embodiments of the present disclosure, the calibration parameters are obtained according to the third deviation value between the first die 11 and the second die 21, and are used for accuracy compensation of the bonding operation between the third die 31 and the fourth die 41. Here, the third deviation value may include multiple third deviation values. Alignment operation is performed on the first die 11 and the second die 21 before determining the multiple third deviation values, and the alignment operation is performed based on the first deviation value and the second deviation value. The third die 31 and the fourth die 41 with accuracy compensation may be bonded directly according to the calibration parameters, so that bonding operations may be reduced, and bonding accuracy is improved.

In some embodiments, the operation of determining at least two third deviation values corresponding to at least two first dies and at least two second dies which have been bonded may include the following operations.

In a process of bonding dies on the wafer in a predetermined order, at least two spaced dies on the wafer are sequentially determined as second dies at a predetermined frequency, here dies other than the second dies on the wafer are fourth dies.

Multiple third deviation values are determined at the predetermined frequency, after bonding the second dies to first dies corresponding to the second dies.

With reference to FIG. 4A, the wafer stage 303 drives the wafer 20 to move at the predetermined frequency, such as in the positive direction of x-axis (as shown by an arrow in the figure), and sequentially bond die 11, die 11' and die 31 at the predetermined frequency. Here, die 21 and die 21' on the wafer 20 spaced at a preset distance from each other may be collectively referred to as the second die, and a to-be-bonded die 41 at any position on the wafer 20 may be the fourth die.

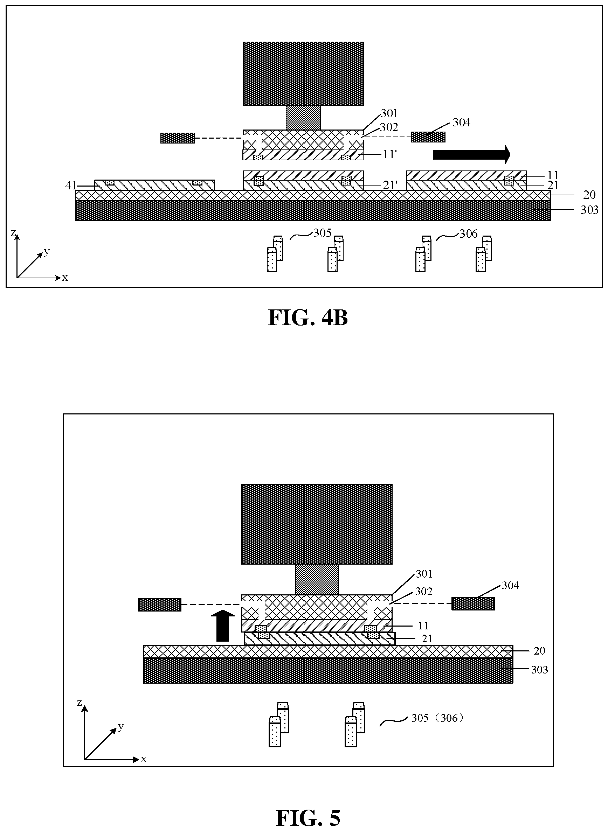

With reference to FIG. 4B, the die 11 and the die 21 are bonded at first according to a preset bonding sequence. At this time, the die 11' may be bonded to the die 21', and synchronously, the third deviation value between the die 11 and the die 21 which have been bonded may be determined by using the third alignment component 306. Here, the third deviation value is a coordinate deviation value and/or an angle deviation value generated during bonding the die 11 to the die 21.

Furthermore, with reference to FIG. 4A, the operation of bonding the die 31 to the die 41 may be performed according to the preset bonding sequence, after bonding the die 11' to the die 21'. At this time, synchronously, the third deviation value between the die 11' and the die 21' which have been bonded may be determined by using the third alignment component 306. Here, the third deviation value is a coordinate deviation value and/or an angle deviation value generated during bonding the die 11' to the die 21'.

It may be understood that FIG. 4A only shows three sets of die to wafer bonding. In the embodiments of the present disclosure, dies on the wafer are sequentially bonded according to the preset sequence. A part of boned dies may be selected at the predetermined frequency to detect them and determine corresponding third deviation values. In order to facilitate understanding, die on the wafer to be detected after bonding is referred to as the second die 21, and corresponding die bonded on the second die 21 is referred to as the first die 11. Other dies are not required to be detected after bonding. Here, they are referred to as the fourth die 41 and the third die 31 to be bonded on the fourth die 41. It may be understood that multiple second dies 21 may be distributed on the same wafer 20, and the second dies 21 may not be adjacent to each other or distributed on the wafer 20 according to a certain rule.

In this way, when each die on the whole wafer 20 is bonded, the third deviation value may be obtained according to a certain frequency, and corresponding calibration parameters may be obtained, to facilitate bonding of other dies. It is to be noted that the second alignment assembly 305 in the present disclosure may also be configured to determine the third deviation value, and the present disclosure does not make too much limitation thereto.

In some embodiments, the operation of determining calibration parameters for the to-be-bonded third die and the fourth die on the wafer, according to the third deviation value may include the following operations.

The calibration parameters are updated according to multiple third deviation values which are available currently, before bonding the to-be-bonded third die to the fourth die on the wafer.

With reference to FIG. 4A, before performing the operation of bonding the third die 31 to the fourth die 41, the third deviation value between the die 11 and the die 21, and the third deviation value between the die 11' and the die 21' may be determined. A corresponding fitting function may be constructed according to the two third deviation values, to perform fitting and determine the calibration parameters based on the two third deviation values.

It may be understood that when dies are continued to be bonded according to the preset sequence, the third deviation value between a next set of dies which have been bonded may be determined. Similarly, fitting may be performed through the three third deviation values, before performing the operation of bonding the third die 31 to the fourth die 41, to determine the calibration parameters based on the three third deviation values.

Here, new calibration parameters based on the three third deviation values will update original calibration parameters based on two third deviation values, thus improving reliability and precision of accuracy compensation.

It is to be noted that the third deviation value between dies which have been bonded previously may be saved by a corresponding storage device and called according to a fitting model.

In the embodiments of the present disclosure, data may be timely called by using the fitting model according to current third deviation values, to perform new fitting, which may have better flexibility, simple operation and higher bonding accuracy.

In some embodiments, the method may further include the following operations.

The first die is debonded from the second die, in response to that the third deviation value is greater than a preset deviation threshold.

In the embodiments of the present disclosure, a relationship between magnitudes of the third deviation value and the preset deviation threshold may be determined by the projection image. Exemplarily, the alignment assembly may include an optical transmitter configured to transmit a detection optical signal, such as a LED, a laser diode, or the like. The alignment assembly may further include a photodetector configured to receive a reflection optical signal, such as a photodiode, a photomultiplier tube, or the like. Furthermore, the photodetector may be connected to an image sensor configured to convert the received reflection optical signal into a visual projection image. In this way, according to a difference between coordinates of the projection image corresponding to the third deviation value and a preset projection image, it may be determined whether the third deviation value is greater than the preset deviation threshold.

It may be understood that when the third deviation value is greater than the preset deviation threshold, it means that there is abnormal die to wafer bonding, for example, displacement deviation or local damage occurs on the die.

With reference to FIG. 5, in response to the third deviation value greater than the preset deviation threshold, the bonding head 301 is driven to re-pick the first die 11 and apply a tensile force to the first die 11, so that the first die 11 has a tendency of vertically moving upward in z direction (as shown by an arrow in the figure). In response to the tensile force greater than a bonding force (such as Van Der Waals force) between the first die 11 and the second die 21, the first die 11 is debonded from the second die 21.

In the embodiments of the present disclosure, debonding operation may be performed when there is abnormal die to wafer bonding, to facilitate reworking dies subsequently, which may improve yield rate of die to wafer bonding.

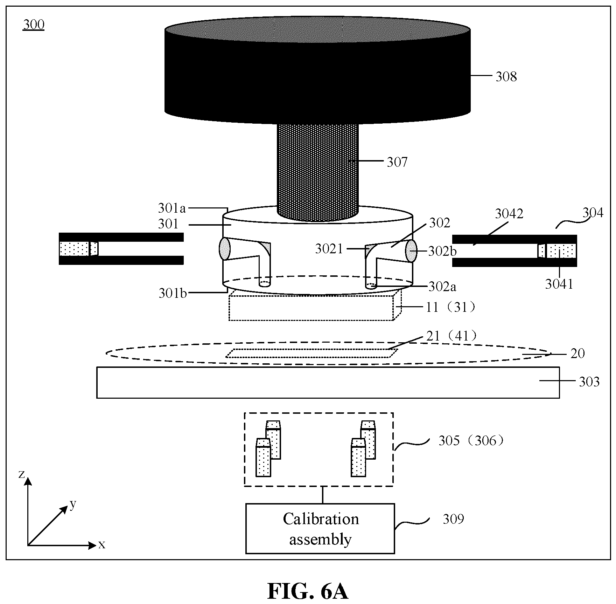

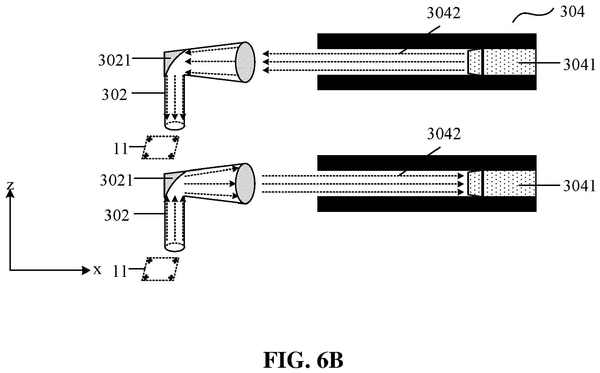

According to a second aspect, with reference to FIG. 6A and FIG. 6B, an embodiment of the present disclosure further provides a bonding system 300 configured to perform the bonding compensation method. The bonding system 300 includes a bonding assembly, a wafer stage 303, a first alignment assembly 304, a second alignment assembly 305, a third alignment assembly 306, and a calibration assembly 309.

The bonding assembly includes a bonding head 301 configured to pick a first die 11 and a first optical path 302 passing through the bonding head 301, here a first end 302a of the first optical path 302 is located at a picking surface 301b where the bonding head 301 picks the first die 11.

The wafer stage 303 is configured to carry a wafer 20.

The first alignment assembly 304 is located at a second end 302b of the first optical path 302, and is configured to determine a first deviation value between a current position of the first die 11 and a first target position according to a detection optical signal transmitted in the first optical path 302.

The second alignment assembly 305 is located at a side of the wafer stage 303 away from the bonding assembly, and is configured to determine a second deviation value between a current position of a second die 21 on the wafer 20 and a second target position.

The wafer stage 303 is further configured to drive, according to the first deviation value and the second deviation value, the carried wafer 20 to move relative to the picking surface 301b, to align the second die 21 with the first die 11.

The bonding assembly is further configured to bond the first die 11 to the second die 21.

The third alignment assembly 306 is located at the side of the wafer stage 303 away from the bonding assembly, and is configured to determine a third deviation value between positions of the first die 11 and the second die 21 which have been bonded.

The calibration assembly 309 is configured to determine calibration parameters for a to-be-bonded third die 31 and a fourth die 41 on the wafer 20, according to the third deviation value.

The bonding assembly is further configured to bond the third die 31 and the fourth die 41 which have been adjusted according to the calibration parameters.

In the embodiment of the present disclosure, the bonding head 301 may have a cylindrical structure in FIG. 6A, and correspondingly, each of the picking surface 301b and a top surface 301a may have a circular shape. The first optical path 302 is located inside the cylindrical structure, and then passes through the bonding head 301, so that the first end 302a and the second end 302b of the first optical path 302 may be located on a surface of the bonding head 301.

The first optical path 302 includes the first end 302a and the second end 302b. The first end 302a is configured to output a detection optical signal and receive a reflection optical signal, and the second end 302b is configured to receive the detection optical signal and output the reflection optical signal. The first optical path 302 allows the detection optical signal and reflection optical signal to pass through, and may be a transparent window arranged in the bonding head 301, or an optical transmission medium arranged in the bonding head 301, such as an optical fiber, a waveguide, or the like.

A first reflector 3021 is included inside the first optical path 302. The first reflector 3021 is located between the first end 302a of the first optical path 302 and the second end 302b of the first optical path 302, and is configured to reflect the detection optical signal received by the second end 302b of the first optical path 302 to the first end 302a of the first optical path 302, and is further configured to reflect the reflection optical signal received by the first end 302a of the first optical path 302 to the second end 302b of the first optical path 302.

It is to be noted that in some other embodiments, the first optical path 302 may directly pass through the bonding head 301 along a z direction in FIG. 6A, that is, a direction perpendicular to the picking surface 301b and the top surface 301a. Then the second end 302b of the first optical path 302 is correspondingly arranged on the top surface 301a of the bonding head 301, so that the first optical path 302 may not be provided with the first reflector 3021.

The bonding head 301 may adsorb the first die 11 by vacuum adsorption or electrostatic adsorption. The first die 11 may include a bonding surface and a non-bonding surface arranged opposite to each other. During die to wafer bonding, the picking surface 301b picks the first die 11 by adsorbing the non-bonding surface of the first die 11. With reference to FIG. 6A, the first die 11 includes a front side and a back side arranged opposite to each other in the z direction. When the front side of the first die 11 is provided with functional structures, the front side of the first die 11 is the bonding surface, and the back side of the first die 11 is the non-bonding surface.

It is to be noted that the first die 11, the second die 21, the third die 31, the fourth die 41 and the wafer 20 are not included in the bonding system 300, and the first die 11, the second die 21, the third die 31, the fourth die 41 and the wafer 20 (shown in dash lines) are merely illustrative in FIG. 6A, to facilitate understanding position relationships among the to-be-bonded die, the bonding head and the wafer during die to wafer bonding.

In some embodiments, the bonding assembly further includes a fixation unit 307 and a mobile unit 308. The fixation unit 307 fixedly connects the top surface 301a of the bonding head 301 to the mobile unit 308. The mobile unit 308 is configured to move the bonding head 301 relative to the wafer stage 303.

The wafer stage 303 may include a chuck (not shown in the figure), such as an ESC chuck, to adsorb the wafer 20.

In some embodiments, a mesa of the wafer stage 303 configured to carry the wafer 20 is not movable itself, however, the wafer stage 303 includes a lift pin which may move relative to the picking surface 301b. The wafer 20 may be driven to move relative to the picking surface 301b by driving the lift pin to move relative to the picking surface 301b, to implement position adjustment of the wafer 20. The lift pin may be provided with a vacuum hole to absorb the wafer through vacuum. The lift pin may move in a plane parallel to the wafer 20, to drive the wafer 20 to move, so as to adjust the position of the wafer 20.

Specifically, the wafer stage 303 including the ESC chuck is taken as an example, the ESC chuck includes a fixed substrate and a lift pin, the lift pin passes through the fixed substrate in an axial direction of the ESC chuck and may move in a direction perpendicular to the fixed substrate and a direction parallel to the fixed substrate. When the ESC chuck carries a wafer 20, the lift pin may contact the wafer 20. When the lift pin moves towards the picking surface 301b in the direction perpendicular to the fixed substrate, the carried wafer 20 is jacked up by the lift pin and thus separated from the fixed substrate, and the carried wafer 20 moves with the lift pin.

The wafer 20 includes multiple second dies 21, each of the second dies 21 includes a substrate and functional structures (such as a storage array or a functional circuit) on the substrate, and a cutting channel is arranged between two adjacent second dies 21.

With reference to FIG. 6B, the first alignment assembly 304 may include an aligner 3041 and a second optical path 3042, here the aligner 3041 is configured to transmit a detection optical signal, receive a reflection optical signal, and determine the first deviation value between the current position of the first die 11 and the first target position. Exemplarily, when the bonding assembly is located at a first position, the aligner 3041 transmits a detection optical signal which is transmitted to a positioning mark (shown by "+" in FIG. 6B) of the first die 11 through the second optical path 3042 and the first optical path 302 to form a reflection optical signal, the reflection optical signal is transmitted back to the aligner 3041 through the first optical path 302 and the second optical path 3042.

The first alignment assembly 304 involved in the embodiments of the present disclosure is located at a side of the wafer stage 303 opposite to the bonding assembly, and determines the first deviation value by the detection optical signal and the reflection optical signal. In contrast, with reference to FIG. 6A, the second alignment assembly 305 and the third alignment assembly 306 are located at a side of the wafer stage 303 facing the bonding assembly, i.e., the side of the wafer stage 303 away from the bonding assembly. It may be understood that the second alignment assembly 305 and the third alignment assembly 306 involved in the embodiments of the present disclosure may be a same set of alignment assemblies or two independent sets of alignment assemblies.

Specifically, the second alignment assembly 305 may determine the second deviation value between the current position of the second die 21 and the second target position, according to a positioning mark of the second die 21 on the wafer 20, and the third alignment assembly 306 may determine the third deviation value according to positioning marks on the first die 11 and the second die 21 which have been bonded.

Exemplarily, with reference to FIG. 6A, after the bonding head 301 of the bonding assembly picks the first die 11, the bonding assembly may move in a horizontal direction (e.g., x direction or y direction) to adjust the bonding assembly to the first position. Here, the first position represents a position where the second end 302b of the first optical path 302 may receive the detection optical signal transmitted by the first alignment assembly 304.

Exemplarily, with reference to FIG. 6A and FIG. 6B, the first alignment assembly 304 transmits the detection optical signal when the bonding assembly is located at the first position, the detection optical signal is transmitted to the positioning mark of the first die 11 through the second end 302b and the first end 302a of the first optical path 302. Here, the positioning mark may be a patterned structure composed of a metal material or another reflective material, so that the detection optical signal forms a reflection optical signal on a surface of the positioning mark, the reflection optical signal is transmitted back to the first alignment assembly 304 through the first end 302a and the second end 302b of the first optical path 302.

In the embodiments of the present disclosure, the first die 11 and the second die 21 which have been bonded are connected on a surface of the wafer 20 by Van Der Waals force. During bonding, the bonding head 301 moves in the vertical direction, which may generate a displacement deviation. Therefore, the third deviation value between positions of the first die 11 and the second die 21 which have been bonded may be determined by the third alignment assembly 306.

Exemplarily, the third alignment assembly 306 is located at a side of the wafer stage 303 facing the bonding assembly and may transmit a detection optical signal. Here, the detection optical signal may be infrared light transmitting silicon materials on the wafer 20, the first die 11 and the second die 21, but reflected by the positioning marks. Similarly, a reflection optical signal formed at the positioning marks is transmitted back to the third alignment assembly 306, so that a projection image between the first positioning mark 110 and the second positioning mark 210 is obtained.

It may be understood that the wafer stage 303 may include a transparent window through which the detection optical signal transmitted by the third alignment assembly 306 is transmitted or which is located outside an optical path of the detection optical signal, so that the detection optical signal may irradiate onto a surface of the wafer 20 contacting the wafer stage 303.

Furthermore, in the embodiments of the present disclosure, the calibration assembly 309 may determine calibration parameters for the third die 31 and the fourth die 41, according to the determined third deviation value. With reference to FIG. 6A, the calibration assembly 309 may be connected to the third alignment assembly 306 through a signal transmission line to transmit data.

Exemplarily, the calibration assembly 309 may include a calculation unit which may perform data fitting on the third deviation value obtained from the third alignment assembly 306, here the calculation unit may be an electronic computer or another computing device. It may be understood that when multiple third deviation values are required to be stored, the calibration assembly 309 may also include a storage unit, here the storage unit may be a cache or flash memory. It is to be noted that in the embodiments of the present disclosure, the calibration assembly 309 may also update the calibration parameters based on the obtained third deviation values.

In some other embodiments, the calibration assembly 309 may also be integrated into the second alignment assembly 305 and the third alignment assembly 306, and the present disclosure does not make too much limitation thereto.

After determining the calibration parameters, the bonding system 300 may perform accuracy compensation on the to-be-bonded third die 31 and the fourth die 41, and use the bonding assembly to drive the bonding head, so that the third die 31 and the fourth die 41 may be bonded.

In the embodiments of the present disclosure, the first deviation value between the first die 11 and the first target position is determined by using the first alignment assembly, the second deviation value between the second die 21 and the second target position is determined by using the second alignment assembly, the third deviation value between the first die 11 and the second die 21 which have been bonded is determined by using the third alignment assembly, the calibration parameters are determined according to the third deviation value, and accuracy compensation of the coordinate deviation value and/or the angle deviation value of the to-be-bonded third die 31 and the fourth die 41 on the wafer is performed, thereby improving efficiency and accuracy of die to wafer bonding.

In some embodiments, the wafer stage may be further configured to drive, according to the calibration parameters, the carried wafer to move relative to the picking surface, so that the third die and the fourth die are located at to-be-bonded positions.

In the embodiments of the present disclosure, the alignment operation is implemented by the wafer stage 303 driving the wafer 20. Exemplarily, according to the determined calibration parameters (such as coordinate deviation value), the wafer 20 may be driven to move by corresponding distances on the x-axis and y-axis relative to the picking surface 301b respectively, so that the third die 31 and the fourth die 41 are located at to-be-bonded positions.

It is to be noted that the to-be-bonded positions are positions after accuracy compensation of the third die 31 and/or the fourth die 41 is performed based on the calibration parameters.

Exemplarily, when the first die 11 is positively bonded to the second die 21, that is, when the third deviation value determined by the bonding operation after aligning the first die 11 with the second die 21 is zero, then the to-be-bonded positions of the third die 31 and the fourth die 41 is positions after alignment. When the third deviation value after bonding the first die 11 to the second die 21 is not zero, the to-be-bonded positions of the third die 31 and the fourth die 41 are positions after accuracy compensation is performed on relative alignment positions.

Furthermore, In the embodiments of the present disclosure, the operation of bonding the third die 31 to the fourth die 41 is performed at the to-be-bonded positions, which may reduce a coordinate deviation value and/or an angle deviation value generated when the bonding head 301 vertically moves downward, thereby improving efficiency and accuracy of die to wafer bonding.

It is to be noted that features disclosed in several method or device embodiments provided in the present disclosure may be arbitrarily combined with each other without conflict, to obtain new method or device embodiments.

The above descriptions are only specific implementations of the present disclosure, however, the scope of protection of the present disclosure is not limited thereto. Variations or replacements easily conceived by any person skilled in the art within the technical scope disclosed in the present disclosure shall fall within the scope of protection of the present disclosure. Therefore, the scope of protection of the present disclosure shall be subject to the scope of protection of the claims.

## Claims

1. A bonding compensation method, comprising:
determining a first deviation value between a current position of a picked first die and a first target position;
determining a second deviation value between a current position of a second die on a wafer and a second target position;
moving the wafer according to the first deviation value and the second deviation value, to align the first die with the second die;
bonding the first die to the second die, after aligning the first die with the second die;
determining a third deviation value between positions of the first die and the second die which have been bonded;
determining calibration parameters for a to-be-bonded third die and a fourth die on the wafer, according to the third deviation value; and
bonding the third die to the fourth die, according to the calibration parameters.

2. The method of claim 1, wherein bonding the third die to the fourth die, according to the calibration parameters comprises:
moving the wafer based on the calibration parameters, so that the third die and the fourth die are located at to-be-bonded positions; and
bonding the third die to the fourth die.

3. The method of claim 2, wherein moving the wafer based on the calibration parameters comprises:
determining a fourth deviation value between a current position of the third die which has been picked and a third target position;
determining a fifth deviation value between a current position of the fourth die on the wafer and a fourth target position; and
moving the wafer according to the fourth deviation value, the fifth deviation value and the calibration parameters, so that the third die and the fourth die are located at the to-be-bonded positions.

4. The method of claim 3, wherein moving the wafer according to the fourth deviation value, the fifth deviation value and the calibration parameters, so that the third die and the fourth die are located at the to-be-bonded positions comprises:
calibrating at least the fourth deviation value or the fifth deviation value based on the calibration parameters; and
moving the wafer according to the fourth deviation value and the fifth deviation value which have been calibrated, so that the third die and the fourth die are located at the to-be-bonded positions.

5. The method of claim 2, wherein moving the wafer based on the calibration parameters, so that the third die and the fourth die are located at the to-be-bonded positions comprises:
moving the wafer to align the third die with the fourth die;
determining a compensation offset based on the calibration parameters; and
moving the wafer according to the compensation offset, so that the third die and the fourth die are located at the to-be-bonded positions.

6. The method of claim 5, wherein moving the wafer to align the third die with the fourth die comprises:
determining a fourth deviation value between a current position of the third die which has been picked and a third target position;
determining a fifth deviation value between a current position of the fourth die on the wafer and a fourth target position; and
moving the wafer according to the fourth deviation value and the fifth deviation value, to align the third die with the fourth die.

7. The method of any one of claims 1 to 6, wherein determining the third deviation value between the positions of the first die and the second die which have been bonded comprises:
determining at least two third deviation values corresponding to at least two first dies and at least two second dies which have been bonded,
determining calibration parameters for the to-be-bonded third die and the fourth die on the wafer, according to the third deviation value comprises:
fitting the at least two third deviation values to obtain a fitting function; and
determining the calibration parameters according to the fitting function.

8. The method of claim 7, wherein determining the at least two third deviation values corresponding to the at least two first dies and at least two second dies which have been bonded comprises:
determining at least two adjacent dies on the wafer as second dies, wherein dies to be bonded after the at least two second dies on the wafer are fourth dies; and
determining the at least two third deviation values, after bonding the at least two second dies to first dies corresponding to the second dies.

9. The method of claim 8, wherein determining the calibration parameters for the to-be-bonded third die and the fourth die on the wafer, according to the third deviation value comprises:
determining the calibration parameters according to the at least two third deviation values, before bonding the fourth dies to be bonded after the second dies to respective third dies.

10. The method of claim 7, wherein determining the at least two third deviation values corresponding to the at least two first dies and at least two second dies which have been bonded comprises:
in a process of bonding dies on the wafer in a predetermined order, sequentially determining at least two spaced dies on the wafer as second dies at a predetermined frequency, wherein dies other than the second dies on the wafer are fourth dies; and
determining a plurality of third deviation values at the predetermined frequency, after bonding the second dies to first dies corresponding to the second dies.

11. The method of claim 10, wherein determining the calibration parameters for the to-be-bonded third die and the fourth die on the wafer, according to the third deviation value comprises:
updating the calibration parameters according to the plurality of third deviation values, before bonding the to-be-bonded third die to the fourth die on the wafer.

12. The method of claim 1, further comprising:
debonding the first die from the second die, in response to that the third deviation value is greater than a preset deviation threshold.

13. A bonding system, comprising:
a bonding assembly comprising a bonding head configured to pick a first die and a first optical path passing through the bonding head, wherein a first end of the first optical path is located at a picking surface where the bonding head picks a die;
a wafer stage configured to carry a wafer;
a first alignment assembly located at a second end of the first optical path, and configured to determine a first deviation value between a current position of the first die and a first target position according to a detection optical signal transmitted in the first optical path;
a second alignment assembly located at a side of the wafer stage away from the bonding assembly, and configured to determine a second deviation value between a current position of a second die on the wafer and a second target position;
the wafer stage further configured to drive, according to the first deviation value and the second deviation value, the carried wafer to move relative to the picking surface, to align the second die with the first die;
the bonding assembly further configured to bond the first die to the second die;
a third alignment assembly located at the side of the wafer stage away from the bonding assembly, and configured to determine a third deviation value between positions of the first die and the second die which have been bonded;
a calibration assembly configured to determine calibration parameters for a to-be-bonded third die and a fourth die on the wafer, according to the third deviation value;
the bonding assembly further configured to bond the third die and the fourth die which have been adjusted according to the calibration parameters.

14. The bonding system of claim 13, wherein the wafer stage is further configured to drive, according to the calibration parameters, the carried wafer to move relative to the picking surface, so that the third die and the fourth die are located at to-be-bonded positions.
